# EUROPÄISCHE PATENTSCHRIFT

(11) **EP 4 043 893 B1**
(45) Veröffentlichungstag und Bekanntmachung des Hinweises auf die Patenterteilung: **25.12.2024**
(21) Anmeldenummer: 22151847.5
(22) Anmeldetag: 17.01.2022
(51) Int. Cl.: G01R 31/14

(54) **SCHALTUNGSANORDNUNG ZUR SPANNUNGSPRÜFUNG UND TEILENTLADUNGSERFASSUNG**
SWITCHING ASSEMBLY FOR VOLTAGE TESTING AND PARTIAL DISCHARGE DETECTION
AGENCEMENT DE CIRCUIT DESTINÉ AU CONTRÔLE DE LA TENSION ET À LA DÉTECTION DE LA DÉCHARGE PARTIELLE

(30) Priorität: 16.02.2021 DE 102021201465
(43) Veröffentlichungstag der Anmeldung: 17.08.2022
(73) Patentinhaber: Kries Energietechnik GmbH & Co. KG, 71334 Waiblingen (DE)
(72) Erfinder: Kries, Gunter, 72384 Weinstadt (DE)
(74) Vertreter: Grünecker Patent- und Rechtsanwälte PartG mbB

(56) Entgegenhaltungen:
- DE-B4- 10 304 396
- DE-U1- 202013 002 563
- US-A1- 2020 003 804

## Beschreibung

Die Erfindung bezieht sich auf eine Schaltungsanordnung zur Spannungsprüfung und Teilentladungserfassung in einer ein- oder mehrphasigen Mittel- oder Hochspannungsanlage nach dem Oberbegriff des Anspruchs 1.

Ein- oder mehrphasige Mittel- oder Hochspannungsanlagen, insbesondere in Form sogenannter Mittel- oder Hochspannungsschaltanlagen, beinhalten bekanntermaßen eine der Anzahl von Phasen entsprechende Anzahl von kurz als Leiter bezeichneten, spannungsführenden elektrischen Leitungen. In den gängigen dreiphasigen Systemen sind dies folglich drei Leiter, die meist abgekürzt als L1, L2 bzw. L3 bezeichnet werden.

Die besagte Schaltungsanordnung dient in solchen Anlagen zum einen zur schwellenbasierten Spannungsprüfung, insbesondere gemäß der Norm IEC 61243-5, und beinhaltet einen oder mehrere Leitersignaleingänge, von denen jeder zur Ankopplung an je eine kapazitive Koppelelektrode eingerichtet ist, die ihrerseits an je einen Leiter der ein- oder mehrphasigen Mittel- oder Hochspannungsanlage angekoppelt ist. An den jeweiligen Leitersignaleingang der Schaltungsanordnung ist eine Spannungsprüfeinheit eingangsseitig angekoppelt, die zur schwellwertbasierten Spannungszustandserfassung bezüglich des zugeordneten Leiters eingerichtet ist.

Zum anderen dient die Schaltungsanordnung in solchen Anlagen zur Erkennung von Teilentladungen an einem jeweiligen Leiter und beinhaltet dazu mindestens eine zur Teilentladungserkennung bezüglich des zugeordneten Leiters eingerichtete Teilentladungsdetektoreinheit, die eine Teilentladungsdetektorschaltung und eine eingangsseitig an einen Signalausgang der Teilentladungsdetektorschaltung angekoppelte Teilentladungs-Anzeigeschaltung umfasst.

Außerdem weist die Schaltungsanordnung eine geeignete Energieversorgung für die Teilentladungsdetektoreinheit auf, wobei die Energieversorgung für die Teilentladungsdetektoreinheit eine erste Energieversorgungsschaltung, die zur Speisung der Teilentladungsdetektorschaltung mit Energie von dem oder einem der Leitersignaleingänge der Schaltungsanordnung eingerichtet ist, und/oder eine zweite Energieversorgungsschaltung umfasst, die zur Speisung der Teilentladungs-Anzeigeschaltung mit Energie von dem oder einem der Leitersignaleingänge der Schaltungsanordnung eingerichtet ist. Die Erfassung und Anzeige von Teilentladungen auf einem jeweiligen Leiter der Mittel- oder Hochspannungsanlage ist bei Vorhandensein der ersten Energieversorgungsschaltung ohne Hilfsenergie für die Teilentladungsdetektorschaltung und bei Vorhandensein der zweiten Energieversorgungsschaltung ohne Hilfsenergie für die Teilentladungs-Anzeigeschaltung möglich. Unter Hilfsenergie ist hierbei jedwede elektrische Energie zu verstehen, die nicht über den jeweiligen Leitersignaleingang der Schaltungsanordnung abgenommen, sondern anderweitig bereitgestellt wird, z.B. durch eine Batterie oder einen Netzspannungsanschluss eines die Schaltungsanordnung beinhaltenden Gerätes. Verglichen mit einer derartigen Verwendung von Hilfsenergie ergibt sich dadurch der Vorteil, dass keine wartungsintensiven Batterien benötigt werden und keine Störsignale berücksichtigt werden müssen, die fälschlich als Teilentladungssignal interpretiert werden könnten und häufig von Schaltnetzteilen verursacht werden, die für den Anschluss solcher Geräte an Netzspannung benutzt werden.

Eine Schaltungsanordnung dieser eingangs genannten, gattungsgemäßen Art ist in der Patentschrift DE 10 2020 214 614 B3 offenbart. Bei der dortigen Schaltungsanordnung ist die Teilentladungsdetektorschaltung eingangsseitig an den oder einen der Leitersignaleingänge der Schaltungsanordnung und über diesen an die betreffende kapazitive Koppelelektrode angekoppelt, um an dieser das Teilentladungssignal abzugreifen.

In ähnlicher Weise ist auch bei einer in der Offenlegungsschrift US 2020/0003804 A1 offenbarten Schaltungsanordnung zur Spannungsprüfung und Teilentladungserfassung die Teilentladungsdetektorschaltung eingangsseitig an den Leitersignaleingang der Schaltungsanordnung und über diesen an die betreffende kapazitive Koppelelektrode angekoppelt. Zusätzlich ist dort eine Ausfallsicherungsschaltung zwischen der Teilentladungsdetektorschaltung und der Spannungsprüfschaltung vorgesehen, um Fehlanzeigen der Spannungsprüfschaltung im Fehlerfall der Teilentladungsdetektorschaltung insbesondere aufgrund von Leiterunterbrechungsfehlern oder Leiterkurzschlussfehlern nach Masse zu verhindern.

Des Weiteren sind verschiedentlich ähnliche Schaltungsanordnungen bekannt, die jedoch zur Speisung der Teilentladungsdetektoreinheit Hilfsenergie in Form von externer bzw. zusätzlich zur Ankopplung an den jeweiligen Leiter der Mittel- oder Hochspannungsanlage bereitgestellter elektrischer Energie verwenden. Eine herkömmliche derartige Ausführung ist z.B. in der Offenlegungsschrift DE 101 34 790 A1 offenbart. So wird in der Teilentladungsdetektorschaltung häufig eine Verstärkereinheit benutzt, die zur Speisung externe Energie benötigt. Und auch die Teilentladungs-Anzeigeschaltung ist in herkömmlichen Ausführungen oftmals so ausgelegt, dass sie Hilfsenergie benötigt. Beispielsweise sind in der Patentschrift EP 0 428 601 B1 und der Offenlegungsschrift WO 97/07411 A1 Schaltungsanordnungen zur Teilentladungserfassung offenbart, die zur Signalverarbeitung der Teilentladungserfassung und/oder für die Anzeige der gewonnenen Teilentladungsinformationen externe Hilfsenergie benötigen.

Die Offenlegungsschrift WO 2017/144091 A1 offenbart eine Schaltungsanordnung zur Teilentladungserfassung an einem elektrischen Objekt wie einer Kabelverbindung zweier Hochspannungskabel, wobei zur Energieversorgung der Schaltungsanordnung eine Batterie oder ein Netzteil oder eine Magnetspule dienen kann, mit der elektrische Energie induktiv an einem der beiden Hochspannungskabel abgegriffen wird.

Für sogenannte Spannungsprüfsysteme, bei denen es sich um Schaltungsanordnungen nur zur schwellwertbasierten Spannungszustandserfassung ohne Teilladungserfassung handelt, sind Ausführungen mit und ohne Hilfsenergie bekannt und z.B. in den Normen VDE0682T415 und IEC61243-5 beschrieben. Die Patentschrift DE 103 04 396 B4 offenbart ein solches Spannungsprüfsystem, das vom Benutzer bedienbare Energieversorgungsmittel aufweist, um dem System nutzerbetätigt Hilfsenergie zur Verfügung stellen zu können.

Es sind auch bereits verschiedentlich Spannungsprüfsysteme zur Spannungsprüfung in Mittel- oder Hochspannungsanlagen bekannt, die zusätzlich über Mittel zur Erkennung eines Leiterbruchs auf der Prüfsignal-Verbindungsleitung von der kapazitiven Koppelelektrode zum Leitersignaleingang der Prüfschaltung verfügen, wie z.B. in den Gebrauchsmusterschriften DE 203 20 394 U1, DE 297 24 824 U1 und DE 20 2004 012 798 U1 offenbart. In der Gebrauchsmusterschrift DE 20 2013 002 563 U1 werden hierfür Installationsüberwachungsmittel vorgeschlagen, die so ausgelegt sind, dass sie eine hochohmige Störung sowohl der Prüfsignal-Verbindungsleitung als auch einer Erdverbindung detektieren können.

Der Erfindung liegt als technisches Problem die Bereitstellung einer Schaltungsanordnung der eingangs genannten Art zugrunde, die insbesondere hinsichtlich ihrer Teilladungserkennungsfähigkeit Vorteile gegenüber dem oben erläuterten Stand der Technik bietet.

Die Erfindung löst dieses Problem durch die Bereitstellung einer Schaltungsanordnung mit den Merkmalen des Anspruchs 1.

Die erfindungsgemäße Schaltungsanordnung umfasst einen Teilentladungs-Anschlusspfad, der zum Ankoppeln einer Eingangsseite der Teilentladungsdetektorschaltung an eine Erdungsseite einer zur kapazitiven Koppelelektrode elektrisch parallelen Anlagesystemkapazität eingerichtet ist. Mit dem Begriff Anlagesystemkapazität ist hierbei eine aus elektrischen Kapazitäten dort, d.h. im Umfeld der betreffenden kapazitiven Koppelelektrode des Systems der Mittel- oder Hochspannungsanlage, ggf. befindlicher Kabel bzw. Leitungen und aus elektrischen Kapazitäten dort ggf. befindlicher Endverschlüsse, insbesondere sogenannter Steckendverschlüsse, gemeint. Diese Anlagesystemkapazität kann vorliegend z.B. dann nennenswert in Erscheinung treten, wenn ein Hochspannungskabel an ein Schaltanlagenfeld der Mittel- oder Hochspannungsanlage angeschlossen ist und die kapazitive Koppelelektrode mit eher kleiner Kapazität dimensioniert ist. Speziell tragen zu der Anlagesystemkapazität Kapazitäten bei, die sich aus Feldsteuerbelägen von Hochspannungs-Kabelsteckern und/oder aus Schirmmänteln von Hochspannungskabeln ergeben und in einer Mittelspannungsanlage stets vorhanden sind, sobald das Mittelspannungs-Kabel an die Anlage angeschlossen wird, wobei diese Anlagesystemkapazität oftmals deutlich größer sein kann als die Koppelkapazität der jeweils vorhandenen kapazitiven Koppelelektrode. Es hat sich gezeigt, dass gerade auch in solchen Fällen die durch die Teilentladungsdetektorschaltung erfolgende Teilentladungserfassung über den Teilentladungs-Anschlusspfad Vorteile gegenüber einer anderweitigen Teilentladungserfassung, wie durch Ankoppeln der Teilentladungsdetektorschaltung an die betreffende kapazitive Koppelelektrode bzw. an den mit dieser Koppelelektrode gekoppelten, zugehörigen Leitersignaleingang der Schaltungsanordnung, bietet.

Die Schaltungsanordnung lässt sich bei Bedarf in einem einzigen Gerät realisieren, das eine kombinierte Spannungsprüfung und Teilentladungserfassung ermöglicht, und eignet sich sowohl für einphasige als auch für mehrphasige, insbesondere dreiphasige, Mittel-/Hochspannungssysteme.

Die Schaltungsanordnung ermöglicht es zudem, die für den Betrieb der Teilentladungsdetektoreinheit und insbesondere von deren Teilentladungsdetektorschaltung und/oder deren Teilentladungs-Anzeigeschaltung benötigte elektrische Energie vorzugsweise ganz, alternativ zum Teil, aus dem am zugehörigen Leitersignaleingang der Schaltungsanordnung anstehenden Messsignal zu entnehmen, insbesondere aus dessen niederfrequentem Signalanteil.

Des Weiteren bietet die Schaltungsanordnung den Vorteil, dass eine aktive Teilentladungserfassung, bestehend aus der Auswertung des anstehenden Eingangssignals und dem Anzeigen des Auswertungsergebnisses, von selbst auf die allein interessierenden Zeiträume beschränkt bleiben kann, in denen am betreffenden Leitersignaleingang der Schaltungsanordung das Messsignal effektiv anliegt, womit gemeint ist, dass das Messsignal in einer für die Spannungsprüfung durch die Spannungsprüfeinheit ausreichenden Signalgröße bzw. Signalstärke vorliegt. In inaktiven Zeiträumen, in denen dieses aktive Messsignal nicht vorliegt, das eine entsprechende Spannungsführungsaktivität auf dem zugehörigen Leiter der Mittel- oder Hochspannungsanlage widerspiegelt, wird keine Teilentladungserfassung benötigt. Indem die Teilentladungsdetektorschaltung und/oder die Teilentladungs-Anzeigeschaltung energetisch über die erste bzw. zweite Energieversorgungsschaltung vom am Leitersignaleingang der Schaltungsanordnung anstehenden Messsignal versorgt wird/werden, bleiben eine oder beide dieser Komponenten für die Teilentladungserfassung mangels ausreichender Energiespeisung von selbst inaktiv, solange kein aktives Messsignal am Leitersignaleingang ansteht.

Durch diese energetische Speisung der Teilentladungsdetektoreinheit aus demselben Messsignal, das der Spannungsprüfeinheit zugeführt wird, kann folglich die Energieversorgung für die Detektion und Anzeige von Teilentladungen über die erste bzw. zweite Energieversorgungsschaltung in einer einstellbaren Abhängigkeit von der Größe bzw. Stärke des Messsignals für die Spannungsprüfung gehalten werden, so dass z.B. unterhalb einer Mindestschwelle für das von der Spannungsprüfeinheit detektierte Vorhandensein der Spannung automatisch die Detektion und Anzeige von Teilentladungen unterbleibt. Dies schützt zudem von selbst vor einer fälschlichen Teilentladungserkennung aufgrund hochfrequenter Störsignale bzw. Störeinkopplungen in den Leitersignaleingang der Schaltungsanordnung, deren Frequenz deutlich über der üblichen Netzfrequenz des normalen, niederfrequenten Messsignals liegt. Denn bei fehlendem aktivem Messsignal bleibt die Teilentladungsdetektoreinheit mangels ausreichender Energieversorgung inaktiv und damit unempfindlich gegen diese Störsignale. Mit anderen Worten macht es die Energieversorgung der Teilentladungserfassung aus dem Messsignal für die Spannungsprüfung möglich, die Teilentladungserfassung ausschließlich für Signale, die mit einem bestimmten niederfrequenten Netzfrequenzsignal gekoppelt sind, hinsichtlich Teilentladung auszuwerten, während hochfrequente Störeinkopplungen ohne niederfrequenten Signalanteil keine Teilentladungsanzeige bewirken.

Um den Energiebedarf für die Teilentladungsdetektion niedrig zu halten, kann sich in entsprechenden Realisierungen die Auswertung der Teilentladungserfassung durch entsprechende Auslegung der Teilentladungsdetektoreinheit einfach darin bestehen, eine Mehrzahl diskreter unterschiedlicher Teilentladungs-Pegelstufen vorzugeben und festzustellen sowie entsprechend zu melden bzw. anzuzeigen, welcher dieser Pegelstufen aktuell vorliegt. In einer einfachsten Ausführung kann es sich um eine rein binäre, zweistufige Meldung und Anzeige handeln, die lediglich anzeigt, ob eine Teilentladung vorhanden ist oder nicht.

In einer entsprechenden Ausführung ist die Schaltungsanordnung in der Lage, die Spannungsprüfung und die Teilentladungserfassung im Rahmen eines kombinierten mehrphasigen Prüf- und Anzeigesystems vorzunehmen. Insbesondere kann die Schaltungsanordnung für jeden von mehreren Leitern der jeweils zu überwachenden Mittel- oder Hochspannungsanlage oder nur für einen Teil aller Leiter dieser Anlage die zugeordnete Spannungsprüfeinheit aufweisen. Analog kann die Schaltungsanordnung je nach Bedarf für jeden von mehreren Leitern der Mittel- oder Hochspannungsanlage oder nur für einen Leiter bzw. nur einen Teil aller Leiter der Anlage die jeweils zugeordnete Teilentladungsdetektoreinheit aufweisen. Eine Verwendung der Teilentladungsdetektoreinheit nur an einer von mehreren Phasen eines mehrphasigen Systems minimiert den Schaltungsaufwand und den Energiebedarf. Eine Verwendung der Teilentladungsdetektoreinheit an mehreren bzw. allen Phasen erhöht zwar den Schaltungsaufwand, kann aber bei Bedarf die Melde- bzw. Anzeigeselektivität bezüglich Teilentladungen verbessern.

Bei der Dimensionierung der Schaltungsanordnung ist es nützlich, wenn die energieverbrauchenden Bestandteile der Teilentladungsdetektoreinheit, d.h. die Teilentladungsdetektorschaltung und die Teilentladungs-Anzeigeschaltung, ausreichend hochohmig ausgeführt werden, so dass deren Vorhandensein das Ansprechverhalten der Spannungsprüfeinheit weitestgehend unverändert lässt. Zudem trägt eine solche hochohmige Auslegung der Teilentladungsdetektoreinheit zu einem minimalen Energiebedarf derselben bei, der problemlos über die erste und/oder die zweite Energieversorgungsschaltung vom Messsignal am betreffenden Leitersignaleingang gedeckt werden kann.

In einer Weiterbildung der Erfindung beinhaltet die Schaltungsanordnung einen Umschalter zur umschaltbaren Verbindung der Eingangsseite der Teilentladungsdetektorschaltung entweder mit dem Teilentladungs-Anschlusspfad oder mit dem oder einem der Leitersignaleingänge der Schaltungsanordnung, über den die zugeordnete Spannungsprüfeinheit an die kapazitive Koppelelektrode angekoppelt ist. Dies ermöglicht vorteilhaft eine wahlweise Teilladungserfassung über den Teilentladungs-Anschlusspfad und die Erdungsseite der Anlagensystemkapazität, insbesondere in Situationen mit gegenüber der Kapazität der Koppelelektrode höherer Anlagensystemkapazität bzw. relativ kleiner Koppelelektrodenkapazität, oder über den betreffenden Leitersignaleingang der Schaltungsanordnung und die kapazitive Koppelelektrode, insbesondere in Fällen mit relativ hoher Kapazität der Koppelelektrode bzw. ausreichend hohem Teilentladungssignalpegel an der Koppelelektrode. Alternativ kann vorgesehen sein, die Teilladungserfassung ausschließlich über den Teilentladungs-Anschlusspfad vorzunehmen.

In einer Weiterbildung der Erfindung beinhaltet die Schaltungsanordnung eine Koaxialleitung mit einem Innenleiter, der mindestens einen Teil einer Verbindungsleitung vom jeweiligen Leitersignaleingang zur zugeordneten kapazitiven Koppelelektrode bildet, und einem den Innenleiter umgebenden Außenleiter, der mindestens einen Teil des Teilentladungs-Anschlusspfades bildet. Dies ermöglicht vorteilhaft die Kombination einer geschirmten Ankopplung des betreffenden Leitersignaleingangs und damit der Spannungsprüfung durch die Spannungsprüfeinheit über den Innenleiter an die kapazitive Koppelelektrode mit einer Nutzung des Außenleiters zur Ankopplung der Teilentladungsdetektoreinheit an die Erdungsseite der Anlagensystemkapazität. Alternativ kann die Verbindung vom Leitersignaleingang zur kapazitiven Koppelelektrode durch eine nicht koaxiale Leitung realisiert sein. Des Weiteren kann alternativ der Teilentladungs-Anschlusspfad eine separate Anschlusspfadleitung beinhalten, statt hierfür den Außenleiter der Koaxialleitung zu nutzen.

In einer Weiterbildung der Erfindung sind die Erdungsseite der Anlagesystemkapazität und der an diese angekoppelte Teilentladungs-Anschlusspfad über ein Hochfrequenzsperrelement mit einem Erdpotential verbunden. Das Hochfrequenzsperrelement kann dazu beitragen, an der Erdungsseite der Anlagesystemkapazität das Teilentladungssignal ausreichend hoch zu halten, indem verhindert wird, dass es über das Erdpotential abgeleitet wird. Alternativ kann das Hochfrequenzsperrelement in bestimmten Anwendungsfällen entfallen oder durch eine entsprechend große Länge einer zugehörigen Anschlussleitung ersetzt werden.

In einer Ausgestaltung der Erfindung ist die erste Energieversorgungsschaltung an den gleichen Leitersignaleingang der Schaltungsanordnung wie die Teilentladungsdetektoreinheit oder an einen anderen von mehreren Leitersignaleingängen der Schaltungsanordnung ankoppelbar. Die erstgenannte Alternative ist für einphasige Systeme gegeben und kann auch für mehrphasige Systeme bei Bedarf vorgesehen sein, wenn ein Zugriff der Energieversorgungsschaltung für die Teilentladungsdetektoreinheit auf einen anderen als den von der Teilentladungsdetektoreinheit ggf. genutzten Leitersignaleingang nicht gewünscht ist. Die andere Alternative kann bei mehrphasigen Systemen von Vorteil sein, um beispielsweise die Energieabnahme durch die Schaltungsanordnung auf mehrere Leiter der Mittel-/Hochspannungsanlage möglichst gleichmäßig zu verteilen.

In einer Ausgestaltung der Erfindung ist die zweite Energieversorgungsschaltung an den gleichen Leitersignaleingang der Schaltungsanordnung wie die Teilentladungsdetektoreinheit oder an einen anderen von mehreren Leitersignaleingängen der Schaltungsanordnung ankoppelbar. Auch hier kann diese Maßnahme für die zweite Energieversorgungsschaltung in der einen oder der anderen Alternative je nach Anwendungsfall vorteilhaft sein, wie oben zur ersten Energieversorgungsschaltung erläutert.

Speziell können in einer entsprechenden Realisierung die Teilentladungsdetektoreinheit, die erste Energieversorgungsschaltung und die zweite Energieversorgungsschaltung an drei unterschiedliche Leitersignaleingänge der Schaltungsanordnung angekoppelt sein. Diese Ausführung kann insbesondere für ein dreiphasiges System von Vorteil sein, wobei sie die Energieaufnahme aus den verschiedenen Leitern vergleichmäßigt und die vorzugsweise für alle drei Leiter vorgesehenen Spannungsprüfeinheiten auf allen drei Leitern bzw. Phasen sehr gleichmäßig belastet. Dies trägt dazu bei, dass sich für die Spannungsprüfung über alle drei Phasen bzw. Leiter hinweg ohne Zusatzaufwand eine näherungsweise einheitliche Ansprechschwelle vorgeben lässt.

In einer Weiterbildung der Erfindung weist die Schaltungsanordnung am jeweiligen Leitersignaleingang einen variablen Kondensator zur Bildung eines kapazitiven Spannungsteilers mit der zugeordneten kapazitiven Koppelelektrode auf. Mit diesem variablen Kondensator, d.h. einem Kondensator mit variabel einstellbarer Kapazität, kann bei Bedarf die Ansprechschwelle für die Spannungsprüfung durch die Spannungsprüfeinheit und die Empfindlichkeit für die Teilentladungserfassung durch die Teilentladungsdetektoreinheit variabel eingestellt, d.h. verstellt, werden. Mit größerer Kapazität des variablen Kondensators wird die Teilentladungserfassung unempfindlicher, bei Verkleinerung dieser Kapazität wird sie empfindlicher. Da die Ansprechschwellen für die Spannungsprüfung gemäß der Norm IEC61243-5 für das Nichtansprechen bzw. das Ansprechen der Spannungsanzeige eine relativ hohe Toleranz, nämlich 10% bis 45%, aufweisen, kann die Kapazität des variablen Kondensators in einem entsprechend großen Bereich zur Änderung der Empfindlichkeit der Teilentladungserfassung variiert werden, ohne die Ansprechschwellen der Spannungsanzeige gemäß dieser Norm zu verletzen.

In einer Weiterbildung der Erfindung ist die Teilentladungsdetektoreinheit empfindlichkeitsverstellbar ausgeführt. Die Verstellbarkeit der Empfindlichkeit der Teilentladungsdetektoreinheit kann vorteilhaft z.B. dazu genutzt werden, einen Ansprechpegel für die Teilentladungsdetektion je nach dem gegebenen System ausreichend hoch einzustellen, um Fehlanzeigen zu vermeiden, die von einem Grundrauschen herrühren können, das durch in der Praxis oftmals auftretende, hochfrequente Fremdstörungen bedingt ist. Die Teilentladungsdetektoreinheit umfasst zur Empfindlichkeitsverstellung eine an den Signalausgang der Teilentladungsdetektorschaltung angekoppelte Schaltungskomponente, die einen variablen Kondensator oder ein Potentiometer oder ein einstellbares Widerstandsnetzwerk, d.h. ein Netzwerk aus ohmschen Widerständen mit variabel einstellbarem ohmschem Gesamtwiderstand, aufweist. Dies stellt zusätzlich oder alternativ zu dem erwähnten Anordnen eines variablen Kondensators am Leitersignaleingang eine vorteilhafte Realisierungsmöglichkeit für die Empfindlichkeitsverstellung bezüglich Teilentladungserfassung dar. Die Spannungsprüfeinheit bleibt von dieser Variante der Empfindlichkeitsverstellung der Teilentladungsdetektion unbeeinflusst, so dass mit dieser Variante die Teilentladungsdetektion in ihrer Empfindlichkeit bei Bedarf auch über den Bereich hinaus verstellt werden kann, der bei entsprechender Verstellung der Kapazität des variablen Kondensators am Leitersignaleingang noch nicht zu einer Verletzung der normgemäßen Ansprechschwellen für die Spannungsanzeige der Spannungsprüfung führt.

In einer Weiterbildung der Erfindung weist die Teilentladungsdetektoreinheit ein Deaktivierungselement auf, durch das sie unabhängig von der an den gleichen Leitersignaleingang der Schaltungsanordnung angekoppelten Spannungsprüfeinheit deaktivierbar ist. Mit diesem Deaktivierungselement lässt sich die Teilentladungsdetektoreinheit bei Bedarf deaktivieren, während die Spannungsprüfeinheit aktiv bleiben kann. Dies ermöglicht auf Wunsch Spannungsprüfungen durch die Spannungsprüfeinheit in Zeiträumen, in denen die Teilentladungsdetektoreinheit deaktiviert ist, so dass die Spannungsprüfung vollständig unbeeinflusst von der Teilentladungsdetektoreinheit gehalten werden kann.

In einer Weiterbildung der Erfindung umfasst die Teilentladungs-Anzeigeschaltung eine Anzeigeeinheit und einen zwischen die Anzeigeeinheit und die zweite Energieversorgungsschaltung eingeschleiften, ansteuerbaren Schalter, der mit einem Steuereingang an den Signalausgang der Teilentladungsdetektorschaltung angekoppelt ist. Dies stellt eine vorteilhafte schaltungstechnische Realisierung für die Teilentladungs-Anzeigeschaltung hinsichtlich Energieverbrauch und benötigter Anzeigefunktionalität dar, die nur geringen Schaltungsaufwand erfordert.

In einer Weiterbildung der Erfindung beinhaltet die Schaltungsanordnung einen Detektionsinformations-Anschluss zum Übertragen von Detektionsinformation der Teilentladungsdetektoreinheit nach außen und einen ansteuerbaren Schalter, der mit dem Detektionsinformations-Anschluss verbunden ist, wobei ein Steuereingang des ansteuerbaren Schalters mit dem Signalausgang der Teilentladungsdetektorschaltung verbunden ist. Über den Detektionsinformations-Anschluss kann Information bezüglich einer detektierten Teilentladung nach außen übermittelt werden. Alternativ kann das Ausgangssignal des Schalters natürlich auch innerhalb des Gerätes zum Anschluss einer Fernübertragungsschaltung z.B. mittels Funksender genutzt werden, damit das Teilentladungssignal per Funk an eine Fernwirktechnik gemeldet wird.

In einer Weiterbildung der Erfindung beinhaltet die Schaltungsanordnung einen Diagnose-Anschluss, der mit dem Signalausgang der Teilentladungsdetektorschaltung verbunden ist. Über den Diagnose-Anschluss kann bei erkanntem Vorliegen einer Teilentladung das zugehörige, am Signalausgang der Teilentladungsdetektorschaltung anstehende Teilentladungssignal abgegriffen werden, z.B. um es extern mittels eines Oszilloskops zwecks Diagnose der Ursache der Teilentladung zu untersuchen.

In einer Weiterbildung der Erfindung umfasst die jeweilige Spannungsprüfeinheit eine eingangsseitig an den zugeordneten Leitersignaleingang der Schaltungsanordnung angekoppelte Spannungsprüfschaltung und eine eingangsseitig an einen Signalausgang der Spannungsprüfschaltung angekoppelte Spannungszustands-Anzeigeschaltung. Die Teilentladungs-Anzeigeschaltung der Teilentladungsdetektoreinheit und die Spannungszustands-Anzeigeschaltung der an den gleichen Leitersignaleingang der Schaltungsanordnung angekoppelten Spannungsprüfeinheit weisen hierbei eine gemeinsame Anzeigeeinheit auf. Somit teilen sich die Spannungsprüfeinheit und die Teilentladungsdetektoreinheit vorteilhaft eine gemeinsame Anzeigeeinheit, was dazu beiträgt, den Schaltungsaufwand und den Energiebedarf für die Schaltungsanordnung gering zu halten.

In einer Ausgestaltung der Erfindung weist die Schaltungsanordnung eine Verbindungsleitungs-Überwachungsschaltung auf, die an ein zweites, koppelelektrodenabgewandtes Ende des Außenleiters ankoppelbar ist und dafür eingerichtet ist, eine Potentialabweichung auf dem Außenleiter zu detektieren. Die Verbindungsleitungs-Überwachungsschaltung realisiert ein Installationsüberwachungsmittel, mit dem eine hochohmige Störung des Außenleiters detektiert werden kann, die insbesondere durch einen Leiterbruch der Koaxialleitung verursacht sein kann und mit der typischerweise auch eine hochohmige Störung des Innenleiters und damit der Verbindungsleitung einhergeht. Unter dem Begriff "hochohmige Störung" ist dabei vorliegend eine Störung zu verstehen, die den elektrischen Widerstand der Verbindungsleitung verglichen mit deren normalem, fehlerfreiem Betriebszustand signifikant erhöht, was insbesondere den Fall einschließt, dass die Verbindungsleitung vollständig unterbrochen ist.

In einer weiteren Ausgestaltung der Erfindung beinhaltet die Schaltungsanordnung einen gemeinsamen Anschlussstecker zur simultanen lösbaren Ankopplung der Verbindungsleitungs-Überwachungsschaltung an das zweite Ende des Außenleiters und des Leitersignaleingangs an ein koppelelektrodenabgewandtes Ende des Innenleiters. Damit kann z.B. der Fehlerfall ausgeschlossen werden, dass zwar der Leitersignaleingang an den Innenleiter angeschlossen wurde, jedoch vergessen wurde, zusätzlich auch den Außenleiter an die Verbindungsleitungs-Überwachungsschaltung anzuschließen.

In einer weiteren Ausgestaltung der Erfindung ist die Verbindungsleitungs-Überwachungsschaltung über eine Erdverbindung mit einem Erdpotential verbunden und dafür eingerichtet, eine Potentialabweichung auf der Erdverbindung zu detektieren. In dieser Realisierung kann somit die Verbindungsleitungs-Überwachungsschaltung auch eine hochohmige Störung ihrer Erdverbindung erkennen. Unter dem Begriff "hochohmige Störung" ist dabei hier eine Störung zu verstehen, die den elektrischen Widerstand der Erdverbindung verglichen mit deren normalem, fehlerfreiem Betriebszustand signifikant erhöht, was insbesondere den Fall einschließt, dass die Erdverbindung vollständig unterbrochen ist.

Eine vorteilhafte Ausführungsform der Erfindung ist in der Zeichnung gezeigt. Diese und weitere vorteilhafte Ausführungsformen der Erfindung werden nachfolgend näher erläutert. Hierbei zeigt:

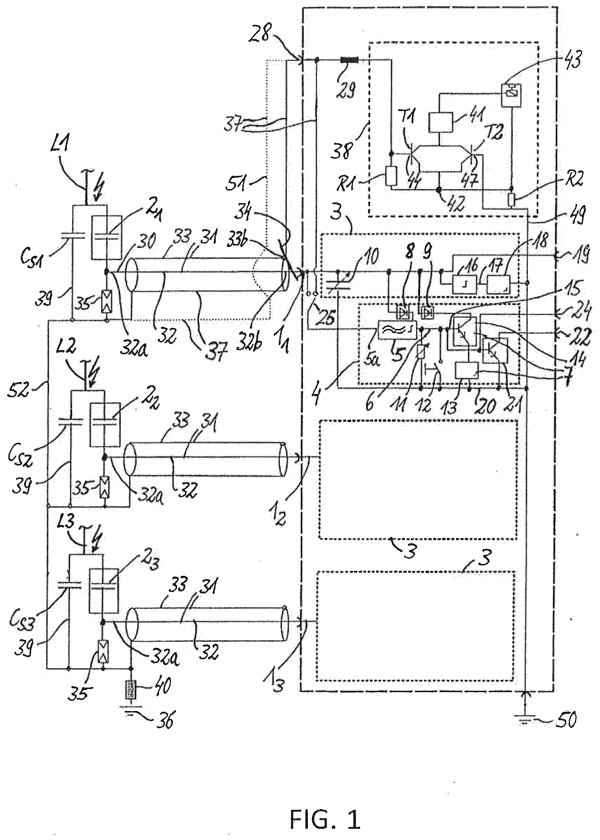

- Fig. 1: ein schematisches Schaltbild einer Schaltungsanordnung zur Spannungsprüfung und Teilentladungserfassung in einer ein- oder mehrphasigen Mitteloder Hochspannungsanlage.

Die in der einzigen Figur 1 in einer exemplarischen Ausführung gezeigte Schaltungsanordnung ist zur Spannungsprüfung und Teilentladungserfassung in einer ein- oder mehrphasigen Mittel- oder Hochspannungsanlage ausgelegt. Hierzu weist sie einen oder mehrere Leitersignaleingänge auf, von denen jeder zur Ankopplung an je eine kapazitive Koppelelektrode eingerichtet ist, die an je einen Leiter der ein- oder mehrphasigen Mittel- oder Hochspannungsanlage angekoppelt ist. Beispielhaft ist die Schaltungsanordnung in Fig. 1 in Ankopplung an drei Leiter L1, L2, L3 einer dreiphasigen Mittel- oder Hochspannungsanlage mit jeweils angekoppelter kapazitiver Koppelelektrode 2₁, 2₂, 2₃ gezeigt. Hierbei ist die Schaltungsanordnung mit je einem Leitersignaleingang 1₁, 1₂, 1₃ an die jeweilige Koppelelektrode 2₁, 2₂, 2₃ des jeweiligen Leiters L1, L2, L3 angekoppelt.

Die gezeigte Schaltungsanordnung beinhaltet je eine eingangsseitig an den zugeordneten Leitersignaleingang 1₁, 1₂, 1₃ angekoppelte Spannungsprüfeinheit 3, die zur schwellwertbasierten Spannungszustandserfassung bezüglich des zugeordneten Leiters L1, L2, L3 eingerichtet ist. Vorzugsweise besitzt die Spannungsprüfeinheit 3 hierzu einen Schaltungsaufbau, wie er für derartige Spannungsprüfeinheiten, die gemäß der Norm IEC61243-5 arbeiten, an sich bekannt ist, was daher hier keiner näheren Erläuterungen bedarf.

Des Weiteren weist die gezeigte Schaltungsanordnung mindestens eine zur Teilentladungserkennung bezüglich des zugeordneten Leiters L1, L2 und/oder L3 eingerichtete Teilentladungsdetektoreinheit 4 auf, die eine Teilentladungsdetektorschaltung 5 und eine eingangsseitig an einen Signalausgang 6 der Teilentladungsdetektorschaltung 5 angekoppelte Teilentladungs-Anzeigeschaltung 7 umfasst.

Außerdem beinhaltet die gezeigte Schaltungsanordnung eine Energieversorgung für die Teilentladungsdetektoreinheit 4, wobei diese Energieversorgung eine erste Energieversorgungsschaltung 8 und/oder eine zweite Energieversorgungsschaltung 9 umfasst. Die erste Energieversorgungsschaltung 8 ist zur Speisung der Teilentladungsdetektorschaltung 5 mit Energie von dem oder einem der Leitersignaleingänge 1₁, 1₂, 1₃ der Schaltungsanordnung eingerichtet, und die zweite Energieversorgungsschaltung 9 ist zur Speisung der Teilentladungs-Anzeigeschaltung 7 mit Energie von dem oder einem der Leitersignaleingänge 1₁, 1₂, 1₃ der Schaltungsanordnung eingerichtet. In vorteilhaften Ausführungen umfasst diese Energieversorgung wie beim gezeigten Beispiel sowohl die erste als auch die zweite Energieversorgungsschaltung 8, 9, in alternativen Ausführungen ist nur eine dieser beiden Energieversorgungsschaltungen 8, 9 vorgesehen. Die erste und die zweite Energieversorgungsschaltung 8, 9 besitzen einen Schaltungsaufbau, der die jeweils von ihr geforderte Funktionalität bereitstellt. In dieser Hinsicht geeignete schaltungstechnische Realisierungen sind dem Fachmann bei Kenntnis dieser vorliegend angegebenen Funktionalität an sich bekannt, was daher hier keiner näheren Erläuterungen bedarf.

In Figur 1 ist die Schaltungsanordnung detaillierter mit ihren an den Leiter L1 angekoppelten Komponenten gezeigt. In gleicher Weise kann die Schaltungsanordnung Schaltungskomponenten umfassen, die an den Leiter L2 bzw. an den Leiter L3 angekoppelt sind, z.B. je eine weitere Spannungsprüfeinheit 3, wie in Fig. 1 angedeutet. Da diese weiteren Schaltungskomponenten identisch zu den gezeigten, an den Leiter L1 angekoppelten Schaltungskomponenten ausgeführt sein können, genügt im Folgenden die Beschreibung der gezeigten Schaltungskomponenten. Dabei ist es in entsprechenden Ausführungen insbesondere möglich, die Spannungsprüfeinheit 3 für alle drei Phasen, d.h. dreiphasig, und die Teilentladungsdetektoreinheit 4 nur für eine Phase, d.h. einphasig, vorzusehen.

Die Spannungsprüfeinheit 3 verfügt in entsprechenden Ausführungen, wie im gezeigten Beispiel, über eine eingangsseitig an den zugeordneten Leitersignaleingang 1₁, 1₂, 1₃ angekoppelte Spannungsprüfschaltung 16, z.B. in Form eines geeigneten herkömmlichen Schwellwertdetektors, und eine eingangsseitig an einen Signalausgang 17 der Spannungsprüfschaltung 16 angekoppelte Spannungszustands-Anzeigeschaltung 18, z.B. in Form einer hierfür an sich bekannten Flüssigkristall(LCD)-Anzeige. Außerdem kann das eingangsseitig über den Leitersignaleingang 1₁, 1₂, 1₃ zugeführte Messsignal parallel zu einem externen Messpunkt 19 der Spannungsprüfeinheit 3 geführt sein, wie gezeigt.

Weiter umfasst die Schaltungsanordnung einen Teilentladungs-Anschlusspfad 37, der zum Ankoppeln einer Eingangsseite 5a der Teilentladungsdetektorschaltung 5 an eine Erdungsseite 39 einer zur jeweiligen kapazitiven Koppelelektrode 2₁, 2₂, 2₃ elektrisch parallelen Anlagesystemkapazität C_{S1}, C_{S2}, C_{S3} eingerichtet ist. Dies ermöglicht die Erfassung von Teilentladungen mittels der Teilentladungsdetektoreinheit 4 an der zur kapazitiven Koppelelektrode 2₁, 2₂, 2₃ elektrisch parallelen Anlagesystemkapazität C_{S1}, C_{S2}, C_{S3} über den Teilentladungs-Anschlusspfad 37. Die jeweilige Anlagesystemkapazität C_{S1}, C_{S2}, C_{S3} setzt sich insbesondere aus elektrischen Kapazitäten von Kabeln, Leitungen und Endverschlüssen, insbesondere Steckendverschlüssen im Umfeld der betreffenden kapazitiven Koppelelektrode 2₁, 2₂, 2₃ des Systems der Mitteloder Hochspannungsanlage zusammen und tritt insbesondere dann nennenswert in Erscheinung, wenn ein Hochspannungskabel an ein Schaltanlagenfeld der Mittel- oder Hochspannungsanlage angeschlossen ist und die kapazitive Koppelelektrode 2₁, 2₂, 2₃ mit eher kleiner Kapazität dimensioniert ist, so dass die Anlagesystemkapazität größer als die Kapazität der Koppelelektrode 2₁, 2₂, 2₃ ist. Speziell tragen hierzu Kapazitäten bei, die sich aus Feldsteuerbelägen von Hochspannungs-Kabelsteckern und/oder aus Schirmmänteln von Hochspannungskabeln ergeben und in einer Mittelspannungsanlage stets vorhanden sind, sobald das Mittelspannungs-Kabel an die Anlage angeschlossen wird. Es zeigt sich, dass gerade auch in solchen Fällen die Teilentladungserfassung über die Erdungsseite 39 dieser Anlagesystemkapazität C_{S1}, C_{S2}, C_{S3} einer Teilentladungserfassung über die kapazitive Koppelelektrode 2₁, 2₂, 2₃ überlegen sein kann.

In vorteilhaften Ausführungsformen weist die Schaltungsanordnung einen Umschalter 25 zur umschaltbaren Verbindung der Eingangsseite 5a der Teilentladungsdetektorschaltung 5 entweder mit dem Teilentladungs-Anschlusspfad 37 oder mit dem oder einem der Leitersignaleingänge 1₁, 1₂, 1₃ auf. Dies ermöglicht es dem Benutzer, auf Wunsch zwischen der Teilentladungserfassung an der jeweiligen Anlagesystemkapazität C_{S1}, C_{S2}, C_{S3} über den Teilentladungs-Anschlusspfad 37 und einer Teilentladungserfassung an der betreffenden kapazitiven Koppelelektrode 2₁, 2₂, 2₃ über den zugehörigen Leitersignaleingang 1₁, 1₂, 1₃ umzuschalten und damit situationsund/oder anlagenabhängig jeweils optimal einzustellen.

So gibt es in Hochspannungsanlagen typischerweise Schaltanlagenfelder in Form sog. Reservefelder, die zumindest vorübergehend ohne Hochspannungskabel betrieben werden. In diesen Feldern wirkt für die Auskoppelung des Teilentladungssignals vorrangig die Kapazität der betreffenden Koppelelektrode 2₁, 2₂, 2₃, über die auch entsprechende Signale von den jeweils anderen Leitern eingekoppelt werden können. In diesem Fall ist daher in der Regel die Ankopplung der Teilentladungsdetektorschaltung 5 an den betreffenden Leitersignaleingang 1₁, 1₂, 1₃ zweckmäßig. Allgemein ist diese Umschaltung der Teilentladungserfassung auf den betreffenden Leitersignaleingang 1₁, 1₂, 1₃, z.B. den Leitersignaleingang 1₁, dann angezeigt, wenn davon ausgegangen werden kann, dass sich die Teilentladung durch genügend große Kapazitäten der Koppelelektroden 2₁, 2₂, 2₃ so gut über alle Leiter L1, L2, L3 koppelt, dass ein genügend großer Teilentladungs-Signalpegel über den zugehörigen Leitersignaleingang, wie den Leitersignaleingang 1₁, und dessen Verbindung zur entsprechenden Koppelelektrode, wie der Koppelelektrode 2₁, ankommt, egal von welchem der Leiter L1, L2, L3 die Teilentladung ursprünglich ausgeht. Wenn hingegen davon auszugehen ist, dass die Kapazitäten der Koppelelektroden 2₁, 2₂, 2₃ für diese Art der Teilentladungs-Signalkoppelung nicht ausreichend groß sind, kann auf die Teilentladungserfassung an der jeweiligen Anlagesystemkapazität C_{S1}, C_{S2}, C_{S3} über den Teilentladungs-Anschlusspfad 37 geschaltet werden. Dies kann z.B. dann der Fall sein, wenn ein Hochspannungskabel an das Schaltanlagenfeld angeschlossen wird, wodurch zusätzliche Kabelkapazitäten oder Kapazitäten der Endverschlüsse wirken, die das hochfrequente Teilentladungssignal bedämpfen oder absaugen. Dieser Effekt wird besonders spürbar, wenn die Kapazität der Koppelelektroden 2₁, 2₂, 2₃ relativ niedrig ist.

In vorteilhaften Ausführungsformen weist die Schaltungsanordnung für eine, zwei oder, wie im gezeigten Beispiel für alle drei Phasen je eine Koaxialleitung 31 mit einem Innenleiter 32, der mindestens einen Teil einer Verbindungsleitung 30 vom jeweiligen Leitersignaleingang 1₁, 1₂, 1₃ zur zugeordneten kapazitiven Koppelelektrode 2₁, 2₂, 2₃ bildet, und einem den Innenleiter 32 umgebenden Außenleiter 33, der mindestens einen Teil des Teilentladungs-Anschlusspfades 37 bildet. Dadurch kann der Außenleiter 33 als Ankopplungs- bzw. Verbindungsleitung fungieren, über welche die Teilentladungsdetektorschaltung 5 an die Erdungsseite 39 der Anlagesystemkapazität C_{S1}, C_{S2}, C_{S3} ankoppelbar ist. In einer alternativen Ausführung beinhaltet der Teilentladungs-Anschlusspfad 37 eine in Fig. 1 punktiert angedeutete, eigenständige Ankopplungsleitung 51 zur Ankopplung der Teilentladungsdetektorschaltung 5 an die Erdungsseite 39 der Anlagesystemkapazität C_{S1}, C_{S2}, C_{S3}, statt hierfür den Außenleiter 33 zu nutzen. Diese Ausführung ist dementsprechend auch dann möglich, wenn die Koaxialleitung 31 nicht vorgesehen ist. Andererseits lässt sich durch die Verwendung der Koaxialleitung 31 die Empfindlichkeit der Teilentladungserkennung auf der betreffenden Phase verbessern, wenn die Teilentladungsdetektorschaltung 5 auf den zugehörigen Leitersignaleingang 1₁, 1₂, 1₃ und damit auf den Innenleiter 32 geschaltet ist.

Im gezeigten Beispiel ist der Außenleiter 33 an einem ersten, koppelelektrodenzugewandten Ende 33a zusammen mit der Erdungsseite 39 der jeweiligen Anlagesystemkapazität C_{S1}, C_{S2}, C_{S3}, d.h. zusammen mit einer Erdleitung der jeweiligen Anlagesystemkapazität C_{S1}, C_{S2}, C_{S3} geerdet, d.h. mit einem Erdpotential 36 verbunden. Zudem ist ein koppelelektrodenzugewandtes Ende 32a des Innenleiters 32 zusammen mit der zugeordneten Koppelelektrode 2₁, 2₂, 2₃ über eine spannungsbegrenzende Sollbruchstelle 35 mit dem Erdpotential 36 verbunden. In vorteilhaften dreiphasigen Realisierungen sind die Erdungsseiten 39 aller drei Anlagesystemkapazitäten C_{S1}, C_{S2}, C_{S3} wie im gezeigten Beispiel über eine gemeinsame Erdleitung 52 miteinander und mit dem Erdpotential 36 verbunden. Alternativ können sie separat voneinander einzeln mit dem Erdpotential 36 verbunden sein.

In entsprechenden Ausführungen sind, wie im gezeigten Beispiel, die Erdungsseite 39 der betreffenden Anlagesystemkapazität C_{S1}, C_{S2}, C_{S3} und der an diese angekoppelte Teilentladungs-Anschlusspfad 37 über ein Hochfrequenzsperrelement 40 mit dem Erdpotential 36 verbunden. Das Hochfrequenzsperrelement 40 kann eine Induktivität oder eine andere herkömmliche elektrische Komponente sein, die verhindert, dass hochfrequente Signale und insbesondere das Teilentladungssignal über das Erdpotential 36 abgeleitet werden, wobei diese Funktion eventuell auch allein durch eine entsprechend ausgelegte Anschlussleitung bewirkt werden kann. Dies kann zur verbesserten Erkennung des Teilentladungssignals durch die angekoppelte Teilentladungsdetektorschaltung 5 beitragen. Im gezeigten Beispiel ist das Hochfrequenzsperrelement 40 gemeinsam für die drei Erdungsseiten 39 der Anlagesystemkapazitäten C_{S1}, C_{S2}, C_{S3} zwischen die gemeinsame Erdleitung 52 und das Erdpotential 36 eingeschleift, in alternativen Ausführungen ohne die gemeinsame Erdleitung 52 befindet sich je ein Hochfrequenzsperrelement 40 zwischen der Erdungsseite 39 der jeweiligen Anlagesystemkapazität C_{S1}, C_{S2}, C_{S3} und dem Erdpotential 36.

Im gezeigten Ausführungsbeispiel ist die erste Energieversorgungsschaltung 8 an den gleichen Leitersignaleingang 1₁, 1₂, 1₃ der Schaltungsanordnung angekoppelt wie die Teilentladungsdetektoreinheit 4, speziell an den zum Leiter L1 führenden Leitersignaleingang 1₁. In nicht gezeigten, alternativen Ausführungsformen der Schaltungsanordnung ist die erste Energieversorgungsschaltung 8 an einen anderen der mehreren Leitersignaleingänge 1₁, 1₂, 1₃ der Schaltungsanordnung angekoppelt wie die zugeordnete Teilentladungsdetektoreinheit 4, deren Teilentladungsdetektorschaltung 5 von der ersten Energieversorgungsschaltung 8 gespeist wird.

Ebenso ist im gezeigten Ausführungsbeispiel die zweite Energieversorgungsschaltung 9 an den gleichen Leitersignaleingang, beispielhaft den Leitersignaleingang 1₁, der Schaltungsanordnung angekoppelt wie die zugeordnete Teilentladungsdetektoreinheit 4, deren Teilentladungs-Anzeigeschaltung 5 von der zweiten Energieversorgungsschaltung 9 versorgt wird. In alternativen Ausführungsformen ist die zweite Energieversorgungsschaltung 9 an einen anderen der mehreren Leitersignaleingänge 1₁, 1₂, 1₃ der Schaltungsanordnung angekoppelt wie die betreffende Teilentladungsdetektoreinheit 4.

Beispielsweise können in einer vorteilhaften Realisierung die Teilentladungsdetektoreinheit 4 mit dem ersten Leiter L1, die erste Energieversorgungsschaltung 8 mit dem zweiten Leiter L2 und die zweite Energieversorgungsschaltung 9 mit dem dritten Leiter L3 der dreiphasigen Mittel-/Hochspannungsanlage verbunden sein, insbesondere für den Fall, dass für dieses dreiphasige System nur eine einzige Teilentladungsdetektoreinheit 4 verwendet wird. Die Spannungsprüfeinheit 3 ist hierbei bevorzugt dreifach vorhanden, je einmal für jeden der drei Leiter L1, L2, L3.

In vorteilhaften Ausführungen beinhaltet die Schaltungsanordnung wie im gezeigten Beispiel einen variablen Kondensator 10 zur Bildung eines kapazitiven Spannungsteilers mit der zugeordneten kapazitiven Koppelelektrode 2₁, 2₂, 2₃. Der zugehörige Leitersignaleingang 1₁, 1₂, 1₃ bildet dann den Mittelabgriff dieses kapazitiven Spannungsteilers. Durch den kapazitiven Spannungsteiler wird das Signal der betreffenden Phase bzw. des betreffenden Leiters L1, L2, L3 auf das Messsignal auf Kleinspannungsniveau heruntergeteilt. Der variable Kondensator 10 kann dazu genutzt werden, die Ansprechschwelle für die von der Spannungsprüfeinheit 3 bewirkte kapazitive Spannungsanzeige einzustellen und gleichzeitig, vorzugsweise unter Einhaltung der in der Norm IEC61243-5 festgelegten Ansprechschwellen für die Spannungsanzeige, die Empfindlichkeit der Teilentladungserfassung durch die Teilentladungsdetektoreinheit 4 variabel einzustellen. Durch Vergrößerung der Kapazität des variablen Kondensators 10 kann die Teilentladungsdetektion unempfindlicher gemacht werden bzw. durch Verkleinerung dieser Kapazität empfindlicher.

Die Teilentladungsdetektorschaltung 5 besitzt einen Schaltungsaufbau, wie er für die gewünschte Funktionalität an sich bekannt ist, was hier keiner näheren Erläuterungen bedarf, beispielsweise unter Verwendung einer Hochpass- oder Bandpassschaltung. Wenn durch die Teilentladungsdetektorschaltung 5 eine vorhandene Teilentladung erkannt wird, z.B. durch Erreichen eines vorgegebenen Teilentladungspegels, gibt die Teilentladungsdetektorschaltung 5 an ihrem Signalausgang 6 ein Detektionssignal ab, das die Teilentladungs-Anzeigeschaltung 7 zum Erzeugen einer entsprechenden Anzeigeinformation aktiviert.

In vorteilhaften Realisierungen umfasst die Teilentladungs-Anzeigeschaltung 7 wie im gezeigten Beispiel eine Anzeigeeinheit 13 und einen zwischen die Anzeigeeinheit 13 und die zweite Energieversorgungsschaltung 9 eingeschleiften, ansteuerbaren Schalter 14, wie einen z.B. als Feldeffekttransistor ausgeführten Halbleiterschalter, wobei dieser ansteuerbare Schalter 14 mit einem Steuereingang 15 an den Signalausgang 6 der Teilentladungsdetektorschaltung 5 angekoppelt ist.

In vorteilhaften Realisierungen der Schaltungsanordnung ist die Teilentladungsdetektoreinheit 4 empfindlichkeitsverstellbar ausgeführt. Hierfür umfasst die Teilentladungsdetektoreinheit 4 im gezeigten Beispiel eine an den Signalausgang 6 der Teilentladungsdetektorschaltung 5 angekoppelte Schaltungskomponente 11, die im gezeigten Fall ein Potentiometer, alternativ einen variablen Kondensator, aufweist. Diese Schaltungskomponente 11 ermöglicht eine separate Verstellung bzw. Justierung der Empfindlichkeit der Teilentladungsdetektoreinheit 4, d.h. eine variable Verstellung von deren Ansprechschwelle, unabhängig von der Einstellung der Ansprechschwellen für die Spannungsprüfeinheit 3 mittels des variablen Kondensators 10.

In vorteilhaften Ausführungen weist die Teilentladungsdetektoreinheit 4 wie im gezeigten Beispiel ein Deaktivierungselement 12 auf, durch das sie deaktivierbar ist, ohne dass dadurch auch die an den gleichen Leitersignaleingang 1₁, 1₂, 1₃ der Schaltungsanordnung angekoppelte Spannungsprüfeinheit 3 deaktiviert wird. Im gezeigten Beispiel dient als Deaktivierungselement 12 ein nutzerbetätigbarer Schalter, der zwischen den Signalausgang 6 der Teilentladungsdetektorschaltung 5 und einer Masseanbindung 20 eingeschleift ist. Im aktiven Betrieb der Teilentladungsdetektoreinheit 4 ist der Schalter geöffnet, und zur Deaktivierung der Teilentladungsdetektoreinheit 4 kann er vom Benutzer geschlossen werden.

In entsprechenden Realisierungen der Schaltungsanordnung verfügt die Teilentladungsdetektoreinheit 4 alternativ oder wie gezeigt zusätzlich zum ansteuerbaren Schalter 14 über einen ansteuerbaren Schalter 21, z.B. wiederum ein Halbleiterschalter. Der Schalter 21 ist einerseits mit der Masseanbindung 20 und andererseits wie gezeigt unmittelbar oder alternativ mittelbar über ein Koppelrelais mit einem Anschluss 22 verbunden, der z.B. das Anschließen an eine Fernwirk-Unterstation herkömmlicher Art ermöglicht, um die Teilentladungs-Detektionsinformation per Fernübertragung zu übermitteln, und auf diese Weise als ein Detektionsinformations-Anschluss fungiert. Ein Steuereingang dieses Schalters 21 wird vom Ausgangssignal der Teilentladungsdetektorschaltung 5 beaufschlagt. Alternativ kann das Ausgangssignal des Schalters 21 auch innerhalb der Schaltungsanordnung bzw. des diese bildenden Gerätes zum Anschluss einer Fernübertragungsschaltung z.B. mittels Funksender genutzt werden, um damit das Teilentladungssignal vom Gerät per Funk an eine Fernwirktechnik zu melden.

Beim gezeigten Ausführungsbeispiel sind die Anzeigeeinheit 13 zum Anzeigen der Information über die Teilentladungsdetektion und die Spannungszustands-Anzeigeschaltung 18 als separate Anzeigeeinheiten ausgeführt, vorzugsweise beide in Form jeweils geeigneter LCD-Anzeigeeinheiten. In alternativen Ausführungen weisen die Teilentladungs-Anzeigeschaltung 7 und die Spannungszustands-Anzeigeschaltung 18 eine gemeinsame Anzeigeeinheit, wiederum vorzugsweise eine LCD-Anzeigeeinheit, auf.

Je nach Bedarf und Anwendungsfall beinhaltet die Teilentladungsdetektorschaltung 5 einen einzelnen Schwellwertdetektor mit vorgegebenem Schwellwert oder mehrere parallel angeordnete Schwellwertdetektoren mit unterschiedlichen Schwellwerten. In letzterem Fall ist nicht nur eine binäre Anzeige über das Vorhandensein oder Fehlen einer Teilentladung möglich, sondern die Detektion bzw. Auswertung hinsichtlich verschieden hoher Teilentladungsschwellwerte, und durch entsprechend angepasste Ausführung der Teilentladungs-Anzeigeschaltung 7 kann dann eine separate Anzeige des jeweils vorliegenden Teilentladungsschwellwertes bzw. Teilentladungspegels erfolgen, d.h. eine Teilentladungsanzeige in mehr als zwei Stufen.

Die erfindungsgemäße Schaltungsanordnung ermöglicht die kombinierte Teilentladungserfassung und Spannungsprüfung mittels eines einzigen Prüfgerätes, wozu die Schaltungsanordnung z.B. in einem gemeinsamen Gehäuse 23 untergebracht sein kann, wie in Fig. 1 schematisch veranschaulicht. Die Schaltungsanordnung verzichtet auf eine strikte Trennung der hochfrequenten und niederfrequenten Anteile des Messsignals auf dem jeweiligen Leitersignaleingang 1₁, 1₂, 1₃, was es erleichtert, aus dem niederfrequenten Signalanteil die für die Auswertung des hochfrequenten Signalanteils zwecks Teilentladungserfassung erforderliche Energie sowie die zum Anzeigen der detektierten Informationen benötigte Energie zu entnehmen. Hilfreich ist hierbei im Fall, dass die Teilentladungsdetektorschaltung 5 an den betreffenden Leitersignaleingang 1₁, 1₂, 1₃ angekoppelt ist, eine ausreichend hochohmige Dimensionierung der Teilentladungsdetektorschaltung 5, was außerdem dazu beiträgt, dass sich das Ansprechverhalten der Spannungsprüfeinheit 3 durch das Vorhandensein der Teilentladungsdetektoreinheit 4 nicht nennenswert verändert.

In vorteilhaften Ausführungsformen weist die Schaltungsanordnung wie im gezeigten Beispiel einen Diagnose-Anschluss 24 auf, der mit dem Signalausgang der Teilentladungsdetektorschaltung 5 verbunden ist, wobei diese Verbindung vorzugsweise direkt ausgeführt ist, d.h. ohne zwischenliegende andere Schaltungskomponenten. Über den Diagnose-Anschluss 24, der sich wie der Detektionsinformations-Anschluss 22 vorzugsweise von außen zugänglich am Gehäuse 23 befindet und wie dieser z.B. als Anschlussbuchse ausgeführt sein kann, lässt sich bei erkanntem Vorliegen einer Teilentladung das zugehörige, am Signalausgang 6 der Teilentladungsdetektorschaltung 5 anstehende Teilentladungssignal abgreifen, z.B. um es extern mittels eines Oszilloskops oder dgl. zwecks Diagnose der Ursache der Teilentladung untersuchen zu können. Hierbei wird das Signal hinter der z.B. als Hochpass ausgeführten Teilentladungsdetektorschaltung 5 abgegriffen und kann mit 50Hz-Schwingungen am externen Messpunkt 19 der Spannungsprüfeinheit 3 korreliert werden. Damit lässt sich erkennen, auf welcher Phase die Teilentladung erzeugt wird. In alternativen Ausführungen fehlt der Diagnose-Anschluss 24, wobei in diesem Fall bei Bedarf der Detektionsinformations-Anschluss 22 dazu verwendet werden kann, entsprechende Teilentladungsinformationen abzugreifen, um diese extern zu untersuchen. In weiteren alternativen Ausführungen fehlt der Detektionsinformations-Anschluss 22, und der Diagnose-Anschluss 24 übernimmt dessen oben genannte Funktionen.

In vorteilhaften Ausführungsformen weist die Schaltungsanordnung in diesem Fall für mindestens eine der drei Phasen bzw. in Zuordnung zu mindestens einer der Koaxialleitungen 31 eine Verbindungsleitungs-Überwachungsschaltung 38 auf, die an ein zweites, koppelelektrodenabgewandtes Ende 33b des Außenleiters 33 ankoppelbar ist und dafür eingerichtet ist, eine Potentialabweichung auf dem Außenleiter 33 zu detektieren und damit den fehlerfreien Verbindungszustand zu überwachen. Zum Anschluss des oder der Außenleiter 33, auch als Schirme bezeichnet, kann auf der Geräteseite ein gemeinsamer Schirmanschlusspunkt 28 oder für jede Phase ein entsprechender separater Schirmanschlusspunkt verwendet werden. Soweit für eine Phase an den Außenleiter 33 der jeweiligen Koaxialleitung 31 keine Verbindungsleitungs-Überwachungsschaltung 38 angekoppelt ist, kann der Außenleiter 33 mit seinem koppelelektrodenabgewandten Ende 33b geerdet sein, z.B. indem er zu einem Erdpotential 50 geführt ist. Der Schirmanschlusspunkt 28 kann zudem wie im gezeigten Beispiel als Eingangsanschluss der Schaltungsanordnung für die Ankopplung der Teilentladungsdetektorschaltung 5 an den zur Erdungsseite 39 der betreffenden Anlagesystemkapazität C_{S1}, C_{S2}, C_{S3} führenden Teilentladungs-Anschlusspfad 37 genutzt werden.

Die Verbindungsleitungs-Überwachungsschaltung 38 ist in der Lage, eine hochohmige Störung des Außenleiters 33 zu detektieren, die insbesondere durch einen Leiterbruch der Koaxialleitung 31 verursacht sein kann und mit der typischerweise auch eine hochohmige Störung des Innenleiters 32 und damit der Verbindungsleitung 30 einhergeht. Die Verbindungsleitungs-Überwachungsschaltung 38 kann vorzugsweise zusammen mit den anderen erwähnten Komponenten der Schaltungsanordnung, wie im gezeigten Beispiel, im gemeinsamen Gehäuse 23 untergebracht sein.

In entsprechenden Realisierungen ist ein in Fig. 1 schematisch angedeuteter gemeinsamer Anschlussstecker 34 zur simultanen lösbaren Ankopplung der Verbindungsleitungs-Überwachungsschaltung 38 an das zweite Ende 33b des Außenleiters 33 und des Leitersignaleingangs 1 an ein koppelelektrodenabgewandtes Ende 32b des Innenleiters 32 vorgesehen. Dadurch wird in vorteilhaft einfacher Weise eine Fehlanzeige vermieden, die daraus resultieren könnte, dass zwar der betreffende Leitersignaleingang 1₁, 1₂, 1₃ an den Innenleiter 32 angeschlossen wurde, jedoch die Verbindungsleitungs-Überwachungsschaltung 38 versehentlich nicht an den Außenleiter 33 angeschlossen wurde.

In entsprechenden Realisierungen ist die Verbindungsleitungs-Überwachungsschaltung 38 wie im gezeigten Beispiel über eine Erdverbindung 49 mit dem Erdpotential 50 verbunden und dafür eingerichtet, eine Potentialabweichung auf der Erdverbindung 49 zu detektieren. Dadurch ist die Verbindungsleitungs-Überwachungsschaltung 38 auch in der Lage, eine hochohmige Störung ihrer Erdverbindung 49 erkennen.

In vorteilhaften Realisierungen umfasst die Verbindungsleitungs-Überwachungsschaltung 38 wie im gezeigten Beispiel ein Anzeigeelement 41 und zwei Schalttransistoren T1, T2, die mit ihrer jeweiligen Schaltstrecke parallel zwischen das Anzeigeelement 41 und einen Massepunkt 42 eingeschleift sind, der ein schaltungsseitiges Massepotential repräsentiert. Die Überwachungsschaltung 38 wird von einer benutzerseitig aktivierbaren Hilfsspannungsversorgung 43 gespeist, bei der es sich z.B. in an sich bekannter Weise um ein Piezoelement oder ein anderes Element handeln kann, das mechanische in elektrische Energie umwandelt. Eine Betätigung dieser Hilfsspannungsversorgung 43 durch einen Benutzer löst einen entsprechenden Überwachungsprüfvorgang aus.

Ein Steueranschluss 44 des ersten Schalttransistors T1 ist an das koppelelektrodenabgewandte Ende 33b des Außenleiters 33 der Koaxialleitung 31 angekoppelt, vorzugsweise wie im gezeigten Beispiel über eine optionale Koppelschaltung mit einer Induktivität 29. Ein Steueranschluss 47 des zweiten Schalttransistors T2 ist an die Erdverbindung 49 angekoppelt. Der schaltungsseitige Massepunkt 42 ist über je einen Widerstand R1, R2 mit dem Steueranschluss 44, 47 des ersten bzw. des zweiten Schalttransistors T1, T2 verbunden.

Die so ausgeführte Überwachungsschaltung 38 bildet zusammen mit dem Außenleiter 33 der Koaxialleitung 31 ein Installationsüberwachungsmittel, durch das sowohl eine hochohmige Störung der Verbindung zwischen dem jeweiligen Leiter L1, L2, L3 und der Spannungsprüfeinheit 3 sowie der Teilentladungsdetektoreinheit 4 als auch eine hochohmige Störung der Erdung der Überwachungsschaltung 38 erkannt werden können. Im störungsfreien Fall liegt der Außenleiter 33 und damit auch die Steuerelektrode 44 des ersten Schalttransistors T1 fest auf dem Erdpotential 36. Ebenso liegt der schaltungsseitige Massepunkt 42 über die Erdverbindung 49 der Überwachungsschaltung 38 fest auf dem Erdpotential 36 bzw. 50. Der erste Schalttransistor T1 nimmt dadurch seinen sperrenden Zustand an. Gleiches gilt für den zweiten Schalttransistor T2. Bei Auslösung eines Überwachungsprüfvorgangs durch Betätigen der Hilfsspannungsversorgung 43 bleibt daher das Anzeigeelement 41 deaktiviert.

Tritt hingegen eine Leitungsunterbrechung der Koaxialleitung 31 oder eine andere hochohmige Störung auf dem Außenleiter 33 auf, geht die Erdung für die Steuerelektrode 44 des ersten Schalttransistors T1 verloren, wodurch der erste Schalttransistor T1 in seinen leitenden Zustand gerät. Damit schließt er einen Strompfad zwischen dem Überwachungsanzeigeelement 41 und dem Massepunkt 42 mit der Folge, dass das Überwachungsanzeigeelement 41 aktiviert wird, wenn ein Überwachungsprüfvorgang ausgelöst wird. Am aktivierten Überwachungsanzeigeelement 41 kann erkannt werden, dass ein Installationsfehler vorliegt. Die gleiche Fehleranzeige ergibt sich für den Fall, dass die Steckverbindung durch den Anschlussstecker 34 nicht ordnungsgemäß hergestellt ist. Denn auch in diesem Fall ist die Steuerelektrode 44 des ersten Schalttransistors T1 nicht fest mit Erdpotential verbunden und bleibt potentialschwebend, so dass der erste Schalttransistor T1 leitend geschaltet wird. Mit anderen Worten erkennt die Überwachungsschaltung 38 die Unterbrechung des Außenleiters 33 an einem Potentialunterschied zwischen den Erdungspunkten bzw. Erdpotentialen 36 und 50.

Über den zweiten Schalttransistor T2 kann als weiterer Installationsfehler der Fall erkannt werden, dass die Überwachungsschaltung 38 mit ihrer Erdverbindung 49 nicht oder nicht ordnungsgemäß an das Erdpotential 50 angekoppelt ist. In diesem Fall geht die feste Anbindung der Steuerelektrode 47 des zweiten Schalttransistors T2 an Erdpotential verloren, wodurch der zweite Schalttransistor T2 in seinen leitenden Zustand versetzt wird und dieser nun einen Anzeigestrompfad zwischen dem Überwachungsanzeigeelement 41 und dem Massepunkt 12 bereitstellt.

Die beiden Schalttransistoren T1, T2 arbeiten unabhängig voneinander, was bedeutet, dass die Überwachungsschaltung 38 in der Lage ist, die geschilderten Installationsfehler bezüglich der Prüfsignal-Verbindungsleitung 30 einerseits und der Erdung der Überwachungsschaltung 38 andererseits sowohl einzeln als auch in Kombination zu erkennen und über das Anzeigeelement 41 anzuzeigen. Dies betrifft eine unvollständige Installation durch eine nicht hergestellte Verbindung über den Anschlussstecker 34, eine unvollständige Installation durch eine fehlende oder ungenügende Erdverbindung der Überwachungsschaltung 38 und einen Leiterbruch bzw. eine hochohmige Störung der Koaxialleitung 31. Dabei fungiert der erste Transistorschalter T1 mit dem zugehörigen peripheren Schaltungsteil als Prüfsignalverbindungsleitungs-Überwachungsschaltungsteil, während der zweite Transistorschalter T2 mit dem zugehörigen peripheren Schaltungsteil als Erdverbindungs-Überwachungsschaltungsteil fungiert. Der Außenleiter 33 fungiert als eine entlang des Innenleiters und damit der Prüfsignal-Verbindungsleitung 30 verlaufende Überwachungsleitung, die an ihrem koppelelektrodenzugewandten Ende 32a an das Erdpotential 36 angeschlossen ist und mit ihrem anderen Ende 32b über den optionalen Anschlussstecker 34 und die optionale Koppelschaltung mit der Induktivität 29 an die Verbindungsleitungs-Überwachungsschaltung 38 angekoppelt ist. Die Induktivität 29 fungiert als Hochfrequenz-Filter zur Vermeidung eines Kurzschlusses des hochfrequenten Teilentladungssignals in Richtung der Überwachungsschaltung 38.

Wenngleich dies bislang nicht explizit erwähnt wurde, versteht es sich, dass das gezeigte Spannungsprüfsystem in üblicher Weise zur Spannungsprüfung von dreiphasiger Hochspannung ausgelegt sein kann und die beschriebene Überwachung und Spannungsprüfung für jede der drei Phasen vorgesehen sein kann. Vorteilhaft ist in diesem Fall, einen gemeinsamen Anschlusspunkt für alle drei Phasen und den jeweiligen überwachten Koaxialkabelschirm bzw. Außenleiter 33 durch eine entsprechend ausgeführte Steckverbindung vorzusehen. Durch die Installationsüberwachungsmaßnahme wird zunächst festgestellt, ob ein Installationsfehler vorliegt. Wenn kein Installationsfehler vorliegt, kann die Spannungsprüfeinheit 3 die normale Spannungsprüfung für die zu überwachende Hochspannungsleitung durchführen.

Bei der Leiterbrucherfassung durch die Überwachungsschaltung 38 kann in aller Regel davon ausgegangen werden, dass ein Leiterbruch eines dreiphasigen Spannungsprüfsystems dann kritisch ist, wenn alle drei Prüfsignal-Verbindungsleitungen 30 eines Dreiphasensystems unterbrochen sind, da in diesem Zustand ein Leiterbruch nicht vom Zustand "spannungsfrei" unterscheiden wäre, während bei einem Leiterbruch einer einzelnen Verbindungsleitung die anderen Verbindungsleitungen immer noch ein Signal führen und den Zustand "Spannung vorhanden" signalisieren würden. Eine dreiphasige Anlage gilt nur dann als "spannungsfrei", wenn für alle drei Phasen Spannungsfreiheit erkannt wird. Aus diesem Grund reicht für die Leiterbrucherfassung die Überwachung von nur einer koaxialen Verbindungsleitung im Allgemeinen bereits aus.

Wie das gezeigte und die weiteren oben erläuterten Ausführungsbeispiele deutlich machen, stellt die Erfindung eine Schaltungsanordnung zur Verfügung, die in einer sehr vorteilhaften Weise die bekannten Überwachungsaufgaben der Teilentladungserfassung und der Spannungsprüfung an Mittel-/Hochspannungsanlagen erfüllt und sich dabei mit relativ geringem Schaltungsaufwand in einem einzigen, diese Funktionen kombinierenden Gerät realisieren lässt und auf Wunsch ohne jegliche Hilfsenergie sowohl für die Spannungsprüfung als auch für die Teilentladungserfassung auskommt. Die Teilentladungserfassung lässt sich automatisch auf die interessierenden Zeiträume begrenzen, in denen ein aktives Messsignal für die Spannungsprüfung ansteht. In anderen Zeiträumen kann die Teilentladungserfassung durch fehlende Energieversorgung wegen Fehlens des Messsignals inaktiv gehalten werden. Zur Durchführung der Teilentladungserfassung kann die zugehörige Teilentladungsdetektoreinheit an die Erdungsseite einer oder mehrerer der zu den kapazitiven Koppelelektroden parallelen Anlagesystemkapazitäten und vorzugsweise umschaltbar auch an mindestens eine der kapazitiven Koppelelektroden angekoppelt werden. Optional kann zusätzlich eine Leiterbrucherkennung als ein integraler Bestandteil der Schaltungsanordnung vorgesehen sein. Die Schaltungsanordnung kann in einem gemeinsamen Gerät bzw. Gerätegehäuse realisiert sein.

## Patentansprüche

1. Schaltungsanordnung zur Spannungsprüfung und Teilentladungserfassung in einer ein- oder mehrphasigen Mittel- oder Hochspannungsanlage, mit
- einem oder mehreren Leitersignaleingängen (1₁, 1₂, 1₃), von denen jeder zur Ankopplung an je eine kapazitive Koppelelektrode (2₁, 2₂, 2₃) eingerichtet ist, die an je einen Leiter (L1, L2, L3) der ein- oder mehrphasigen Mittel- oder Hochspannungsanlage angekoppelt ist,
- mindestens einer eingangsseitig an den oder einen zugeordneten der Leitersignaleingänge (1₁, 1₂, 1₃) der Schaltungsanordnung angekoppelten Spannungsprüfeinheit (3), die zur schwellwertbasierten Spannungszustandserfassung bezüglich des zugeordneten Leiters eingerichtet ist,
- mindestens einer zur Teilentladungserkennung bezüglich des oder eines zugeordneten der Leiter (L1, L2, L3) eingerichteten Teilentladungsdetektoreinheit (4), die eine Teilentladungsdetektorschaltung (5) und eine eingangsseitig an einen Signalausgang (6) der Teilentladungsdetektorschaltung (5) angekoppelte Teilentladungs-Anzeigeschaltung (7) umfasst, und
- einer Energieversorgung für die Teilentladungsdetektoreinheit (4) mit einer ersten Energieversorgungsschaltung (8), die zur Speisung der Teilentladungsdetektorschaltung (5) mit Energie von dem oder einem der Leitersignaleingänge (1₁, 1₂, 1₃) der Schaltungsanordnung eingerichtet ist, und/oder mit einer zweiten Energieversorgungsschaltung (9), die zur Speisung der Teilentladungs-Anzeigeschaltung (7) mit Energie von dem oder einem der Leitersignaleingänge (1₁, 1₂, 1₃) der Schaltungsanordnung eingerichtet ist,
- einem Teilentladungs-Anschlusspfad (37), der zum Ankoppeln einer Eingangsseite (5a) der Teilentladungsdetektorschaltung (5) an eine Erdungsseite (39) einer zur kapazitiven Koppelelektrode (2₁, 2₂, 2₃) elektrisch parallelen Anlagesystemkapazität (C_{S1}, C_{S2}, C_{S3}) eingerichtet ist.

2. Schaltungsanordnung nach Anspruch 1, weiter **gekennzeichnet durch** einen Umschalter (25) zur umschaltbaren Verbindung der Eingangsseite (5a) der Teilentladungsdetektorschaltung (5) entweder mit dem Teilentladungs-Anschlusspfad (37) oder mit dem oder einem der Leitersignaleingänge (1₁, 1₂, 1₃).

3. Schaltungsanordnung nach Anspruch 1 oder 2, weiter **gekennzeichnet durch** eine Koaxialleitung (31) mit einem Innenleiter (32), der mindestens einen Teil einer Verbindungsleitung (30) vom jeweiligen Leitersignaleingang (1₁, 1₂, 1₃) zur zugeordneten kapazitiven Koppelelektrode (2₁, 2₂, 2₃) bildet, und einem den Innenleiter (32) umgebenden Außenleiter (33), der mindestens einen Teil des Teilentladungs-Anschlusspfades (37) bildet.

4. Schaltungsanordnung nach einem der Ansprüche 1 bis 3, weiter **dadurch gekennzeichnet, dass** die Erdungsseite (39) der Anlagesystemkapazität (C_{S1}, C_{S2}, C_{S3}) und der an diese angekoppelte Teilentladungs-Anschlusspfad (37) über ein Hochfrequenzsperrelement (40) mit einem Erdpotential (36) verbunden sind.

5. Schaltungsanordnung nach einem der Ansprüche 2 bis 4, weiter **dadurch gekennzeichnet, dass**
- die erste Energieversorgungsschaltung (8) an den gleichen Leitersignaleingang (1₁, 1₂, 1₃) der Schaltungsanordnung wie die Teilentladungsdetektoreinheit (4) oder an einen anderen von mehreren Leitersignaleingängen (1₁, 1₂, 1₃) der Schaltungsanordnung ankoppelbar ist und/oder
- die zweite Energieversorgungsschaltung (9) an den gleichen Leitersignaleingang (1₁, 1₂, 1₃) der Schaltungsanordnung wie die Teilentladungsdetektoreinheit (4) oder an einen anderen von mehreren Leitersignaleingängen (1₁, 1₂, 1₃) der Schaltungsanordnung ankoppelbar ist.

6. Schaltungsanordnung nach einem der Ansprüche 1 bis 5, weiter **gekennzeichnet durch** einen variablen Kondensator (10) am jeweiligen Leitersignaleingang (1₁, 1₂, 1₃) zur Bildung eines kapazitiven Spannungsteilers mit der zugeordneten kapazitiven Koppelelektrode (2₁, 2₂, 2₃).

7. Schaltungsanordnung nach einem der Ansprüche 1 bis 6, weiter **dadurch gekennzeichnet, dass**
- die Teilentladungsdetektoreinheit (4) zur Empfindlichkeitsverstellung eine an den Signalausgang der Teilentladungsdetektorschaltung (5) angekoppelte Schaltungskomponente (11) umfasst, die einen variablen Kondensator oder ein Potentiometer oder ein einstellbares Widerstandsnetzwerk aufweist, und/oder
- die Teilentladungsdetektoreinheit (4) ein Deaktivierungselement (12) aufweist, durch das sie unabhängig von der Spannungsprüfeinheit (3) deaktivierbar ist.

8. Schaltungsanordnung nach einem der Ansprüche 1 bis 7, weiter **dadurch gekennzeichnet, dass** die Teilentladungs-Anzeigeschaltung (7) eine Anzeigeeinheit (13) und einen zwischen die Anzeigeeinheit (13) und die zweite Energieversorgungsschaltung (9) eingeschleiften Halbleiterschalter (14) umfasst, der mit einem Steuereingang (15) an den Signalausgang (6) der Teilentladungsdetektorschaltung (5) angekoppelt ist.

9. Schaltungsanordnung nach einem der Ansprüche 1 bis 8, weiter **gekennzeichnet durch**
- einen Detektionsinformations-Anschluss (22) zum Übertragen von Detektionsinformation der Teilentladungsdetektoreinheit (4) nach außen und
- einen ansteuerbaren Schalter (21), der mit dem Detektionsinformations-Anschluss (22) verbunden ist, wobei ein Steuereingang des ansteuerbaren Schalters (21) mit dem Signalausgang (6) der Teilentladungsdetektorschaltung (5) verbunden ist.

10. Schaltungsanordnung nach einem der Ansprüche 1 bis 9, weiter **gekennzeichnet durch** einen Diagnose-Anschluss (24), der mit dem Signalausgang (6) der Teilentladungsdetektorschaltung (5) verbunden ist.

11. Schaltungsanordnung nach einem der Ansprüche 1 bis 10, weiter **dadurch gekennzeichnet, dass**
- die jeweilige Spannungsprüfeinheit (3) eine eingangsseitig an den zugeordneten Leitersignaleingang (1₁, 1₂, 1₃) der Schaltungsanordnung angekoppelte Spannungsprüfschaltung (16) und eine eingangsseitig an einen Signalausgang (17) der Spannungsprüfschaltung angekoppelte Spannungszustands-Anzeigeschaltung (18) umfasst und
- die Teilentladungs-Anzeigeschaltung (7) der Teilentladungsdetektoreinheit (4) und die Spannungszustands-Anzeigeschaltung (18) der Spannungsprüfeinheit (3) eine gemeinsame Anzeigeeinheit aufweisen.

12. Schaltungsanordnung nach einem der Ansprüche 3 bis 11, weiter **gekennzeichnet durch** eine Verbindungsleitungs-Überwachungsschaltung (38), die an ein zweites, koppelelektrodenabgewandtes Ende (33b) des Außenleiters (33) ankoppelbar ist und dafür eingerichtet ist, eine Potentialabweichung auf dem Außenleiter (33) zu detektieren.

13. Schaltungsanordnung nach Anspruch 12, weiter **gekennzeichnet durch** einen gemeinsamen Anschlussstecker (34) zur simultanen lösbaren Ankopplung sowohl der Verbindungsleitungs-Überwachungsschaltung (38) an das zweite Ende (33b) des Außenleiters (33) als auch des jeweiligen Leitersignaleingangs (1₁, 1₂, 1₃) an ein koppelelektrodenabgewandtes Ende (32b) des Innenleiters (32).

14. Schaltungsanordnung nach Anspruch 12 oder 13, weiter **dadurch gekennzeichnet, dass** die Verbindungsleitungs-Überwachungsschaltung (38) über eine Erdverbindung (49) mit einem Erdpotential (50) verbunden und dafür eingerichtet ist, eine Potentialabweichung auf der Erdverbindung (49) zu detektieren.

## Claims

1. A circuit arrangement for voltage testing and for detecting partial discharges in a single-phase or polyphase medium-voltage or high-voltage installation, comprising
- one or more conductor signal inputs (1₁, 1₂, 1₃), each of which is set up for coupling to a capacitive coupling electrode (2₁, 2₂, 2₃) which is coupled to a conductor (L1, L2, L3) of the single-phase or polyphase medium-voltage or high-voltage system,
at least one voltage testing unit (3) coupled on the input side to the or an associated one of the conductor signal inputs (1₁, 1₂, 1₃) of the circuit arrangement, which is set up for threshold-based detection of the voltage state with respect to the associated conductor,
at least one partial discharge detector unit (4) set up to detect partial discharges with respect to the or an associated one of the conductors (L1, L2, L3), which comprises a partial discharge detector circuit (5) and a partial discharge display circuit (7) coupled on the input side to a signal output (6) of the partial discharge detector circuit (5), and
- a power supply for the partial discharge detector unit (4) having a first power supply circuit (8) which is arranged to supply the partial discharge detector circuit (5) with power from the or one of the conductor signal inputs (1₁, 1₂, 1₃) of the circuit arrangement, and/or with a second power supply circuit (9) which is arranged to supply energy from the or one of the conductor signal inputs (1₁, 1₂, 1₃) of the circuit arrangement to the partial discharge display circuit (7),
a partial discharge terminal path (37) which is set up to couple an input side (5a) of the partial discharge detector circuit (5) to an earth side (39) of a system capacity (C_{S1}, C_{S2}, Css) electrically parallel to the capacitive coupling electrode (2₁, 2₂, 2₃).

2. The circuit arrangement according to claim 1, **characterized by** a changeover switch (25) for switchable connection of the input side (5a) of the partial discharge detector circuit (5) either to the partial discharge connection path (37) or to the or one of the conductor signal inputs (1₁, 1₂, 1₃).

3. The circuit arrangement according to claim 1 or 2, further **characterized by** a coaxial line (31) having an inner conductor (32) which forms at least part of a connecting line (30) from the respective conductor signal input (1₁, 1₂, 1₃ ) to the associated capacitive coupling electrode (2₁, 2₂, 2₃), and an outer conductor (33) surrounding the inner conductor (32) and forming at least part of the partial discharge terminal path (37).

4. The circuit arrangement according to one of the claims 1 to 3, **characterized in that** the earth side (39) of the system capacitance (C_{S1}, C_{S2}, C_{S3}) and the partial discharge terminal path (37) coupled thereto are connected to an earth potential (36) via a highfrequency blocking element (40).

5. The circuit arrangement according to one of the claims 2 to 4, **characterized in that**
- the first power supply circuit (8) can be coupled to the same conductor signal input (1₁, 1₂, 1₃) of the circuit arrangement as the partial discharge detector unit (4) or to another of a plurality of conductor signal inputs (1₁, 1₂, 1₃) of the circuit arrangement, and/or
- the second power supply circuit (9) can be coupled to the same conductor signal input (1₁, 1₂, 1₃) of the circuit arrangement as the partial discharge detector unit (4) or to another of a plurality of conductor signal inputs (1₁, 1₂, 1₃) of the circuit arrangement.

6. The circuit arrangement according to one of the claims 1 to 5, **characterized by** a variable capacitor (10) at the respective conductor signal input (1₁, 1₂, 1₃) for forming a capacitive voltage divider with the associated capacitive coupling electrode (2₁, 2₂, 2₃).

7. The circuit arrangement according to one of claims 1 to 6, further **characterized in that**
- the partial discharge detector unit (4) for sensitivity adjustment comprises a circuit component (11) coupled to the signal output of the partial discharge detector circuit (5), which has a variable capacitor or a potentiometer or an adjustable resistor network, and/or
- the partial discharge detection unit (4) has a deactivating element (12) by means of which it can be deactivated independently of the voltage testing unit (3).

8. The circuit arrangement according to one of claims 1 to 7, further **characterized in that** the partial discharge indicating circuit (7) comprises an indicating unit (13) and a semiconductor switch (14) which is looped in between the indicating unit (13) and the second power supply circuit (9) and having a control input (15) coupled to the signal output (6) of the partial discharge detector circuit (5).

9. The circuit arrangement according to one of claims 1 to 8, further **characterized by**
- a detection information connection (22) for transmitting detection information from the partial discharge detector unit (4) to the outside and
- a controllable switch (21) which is connected to the detection information connection (22), a control input of the controllable switch (21) being connected to the signal output (6) of the partial discharge detector circuit (5).

10. The circuit arrangement according to one of claims 1 to 9, **characterized by** a diagnosis connection (24) which is connected to the signal output (6) of the partial discharge detector circuit (5).

11. The circuit arrangement according to one of claims 1 to 10, **characterized by**
the respective voltage testing unit (3) comprises a voltage testing circuit (16), which is coupled on the input side to the associated conductor signal input (1₁, 1₂, 1₃) of the circuit arrangement, and a voltage state indicating circuit (18), which is coupled on the input side to a signal output (17) of the voltage testing circuit, and
- the partial discharge indicating circuit (7) of the partial discharge detector unit (4) and the voltage state indicating circuit (18) of the voltage testing unit (3) have a common indicating unit.

12. The circuit arrangement according to one of claims 3 to 11, **characterized by** a connecting line monitoring circuit (38) which can be coupled to a second end (33b) of the external conductor (33) facing away from the coupling electrode and is set up to detect a potential deviation on the external conductor (33).

13. The circuit arrangement according to claim 12, **characterized by** a common connector (34) for simultaneously and detachably coupling both the connecting line monitoring circuit (38) to the second end (33 b) of the external conductor (33) and of the respective conductor signal input (1₁, 1₂, 1₃) to an end (32b) of the internal conductor (32) facing away from the coupling electrode.

14. The circuit arrangement according to claim 12 or 13, further **characterized in that** the connecting line monitoring circuit (38) is connected to an earth potential (50) via an earth connection (49) and is set up to detect a potential deviation on the earth connection (49).

## Revendications

1. Agencement de circuit destiné au contrôle de tension et à la détection de décharges partielles dans une installation moyenne ou haute tension monophasée ou multiphasée, comportant
- une ou plusieurs entrées de signal conducteur (1₁, 1₂, 1₃) toutes configurées pour un couplage à une électrode de couplage capacitif (2₁, 2₂, 2₃), chacune étant couplée à un conducteur (L1, L2, L3) de l'installation moyenne ou haute tension monophasée ou multiphasée,
- au moins une unité de contrôle de tension (3) couplée côté entrée à l'entrée ou à l'une des entrées de signal conducteur (1₁, 1₂, 1₃) associée de l'agencement de circuit, qui est configurée pour une détection de l'état de tension basée sur un seuil par rapport au conducteur associé,
- au moins une unité de détection de décharges partielles (4) configurée pour la détection de décharges partielles par rapport au conducteur ou à un conducteur (L1, L2, L3) associé, qui comporte un circuit de détection de décharges partielles (5) et un circuit d'affichage de décharges partielles (7) couplé côté entrée à une sortie de signal (6) du circuit de détection de décharges partielles (5), et
- une alimentation électrique pour l'unité de détection de décharges partielles (4), avec un premier circuit d'alimentation électrique (8) qui est configuré pour alimenter le circuit de détection de décharges partielles (5) en énergie provenant de l'entrée ou de l'une des entrées de signal conducteur (1₁, 1₂, 1₃) de l'agencement de circuit, et/ou avec un deuxième circuit d'alimentation électrique (9) qui est configuré pour alimenter le circuit d'affichage de décharges partielles (7) en énergie provenant de l'entrée ou de l'une des entrées de signal conducteur (1₁, 1₂, 1₃) de l'agencement de circuit,
- un chemin de connexion de décharge partielle (37), qui est configuré pour coupler un côté entrée (5a) du circuit de détection de décharge partielle (5) à un côté terre (39) d'une capacité du système (Cₛ₁, Cₛ₂, Cₛ₃) qui est électriquement parallèle à l'électrode de couplage capacitif (2₁, 2₂, 2₃).

2. Agencement de circuit selon la revendication 1, **caractérisé en outre par** un commutateur (25) pour la connexion commutable du côté entrée (5a) du circuit de détection de décharges partielles (5) soit au chemin de connexion de décharges partielles (37), soit à l'entrée ou à l'une des entrées de signal conducteur (1₁, 1₂, 1₃).

3. Agencement de circuit selon la revendication 1 ou 2, **caractérisé en outre par** une ligne coaxiale (31) avec un conducteur interne (32) qui connecte au moins une partie d'une ligne de connexion (30) à partir de l'entrée de signal de conducteur respectif (1₁, 1₂, 1₃) à l'électrode de couplage capacitif associée (2₁, 2₂, 2₃), et un conducteur externe (33) entourant le conducteur interne (32), qui forme au moins une partie du chemin de connexion de décharge partielle (37).

4. Agencement de circuit selon l'une des revendications 1 à 3, **caractérisé en outre en ce que** le côté terre (39) de la capacité du système (Cₛ₁, Cₛ₂, Cₛ₃) et le chemin de connexion de décharge partielle (37) qui y est couplé sont connectés à un potentiel de terre (36) via un élément de blocage haute fréquence (40).

5. Agencement de circuit selon l'une des revendications 2 à 4, **caractérisé en outre en ce que**
- le premier circuit d'alimentation électrique (8) peut être couplé à la même entrée de signal conducteur (1₁, 1₂, 1₃) de l'agencement de circuit que l'unité de détection de décharges partielles (4) ou à une autre entrée parmi plusieurs entrées de signal de conducteur (1₁, 1₂, 1₃) de l'agencement de circuit, et/ou
- le deuxième circuit d'alimentation électrique (9) peut être couplé à la même entrée de signal conducteur (1₁, 1₂, 1₃) de l'agencement de circuit que l'unité de détection de décharges partielles (4) ou à une autre entrée parmi plusieurs entrées de signal de conducteur (1₁, 1₂, 1₃) de l'agencement de circuit.

6. Agencement de circuit selon l'une des revendications 1 à 5, **caractérisé en outre par** un condensateur variable (10) sur l'entrée de signal de conducteur respective (1₁, 1₂, 1₃) pour former un diviseur de tension capacitif avec l'électrode de couplage capacitif associée (2₁, 2₂, 2₃).

7. Agencement de circuit selon l'une des revendications 1 à 6, **caractérisé en outre en ce que**
- l'unité de détection de décharges partielles (4) pour le réglage de la sensibilité comprend un composant de circuit (11) couplé à la sortie de signal du circuit de détection de décharges partielles (5), qui comporte un condensateur variable ou un potentiomètre ou un réseau de résistances réglable, et/ ou
- l'unité de détection de décharges partielles (4) comporte un élément de désactivation (12) grâce auquel elle peut être désactivée indépendamment de l'unité de contrôle de tension (3).

8. Agencement de circuit selon l'une des revendications 1 à 7, **caractérisé en outre en ce que** le circuit d'affichage de décharges partielles (7) comprend une unité d'affichage (13) et un commutateur à semi-conducteur (14) bouclé entre l'unité d'affichage (13) et le deuxième circuit d'alimentation électrique (9) qui, avec une entrée de commande (15), est couplé à la sortie de signal (6) du circuit de détection de décharges partielles (5).

9. Agencement de circuit selon l'une des revendications 1 à 8, **caractérisé en outre par**
- une connexion d'informations de détection (22) pour transmettre de l'information de détection de l'unité de détection de décharges partielles (4) vers l'extérieur, et
- un commutateur commandable (21) qui est connecté à la connexion d'informations de détection (22), dans lequel une entrée de commande du commutateur commandable (21) est connectée à la sortie de signal (6) du circuit de détection de décharges partielles (5).

10. Agencement de circuit selon l'une des revendications 1 à 9, **caractérisé en outre par** une connexion de diagnostic (24) qui est connectée à la sortie de signal (6) du circuit de détection de décharges partielles (5).

11. Agencement de circuit selon l'une des revendications 1 à 10, **caractérisé en outre en ce que**
- l'unité de contrôle de tension (3) respective comprend un circuit de contrôle de tension (16) couplé côté entrée à l'entrée de signal de conducteur associée (1₁, 1₂, 1₃) de l'agencement de circuit et un circuit d'affichage d'état de tension (18) couplé côté entrée à une sortie de signal (17) du circuit de contrôle de tension, et
- le circuit d'affichage de décharges partielles (7) de l'unité de détection de décharges partielles (4) et le circuit d'affichage d'état de tension (18) de l'unité de contrôle de tension (3) ont une unité d'affichage commune.

12. Agencement de circuit selon l'une des revendications 3 à 11, **caractérisé en outre par** un circuit de surveillance de ligne de connexion (38) qui peut être couplé à une deuxième extrémité (33b) du conducteur externe (33) opposée à l'électrode de couplage et qui est configuré pour détecter une déviation de potentiel sur le conducteur externe (33).

13. Agencement de circuit selon la revendication 12, **caractérisé en outre par** une fiche de connexion commune (34) pour le couplage amovible simultané du circuit de surveillance de ligne de connexion (38) à la deuxième extrémité (33b) du conducteur externe (33) et de l'entrée de signal de conducteur respective (1₁, 1₂, 1₃) à une extrémité (32b) du conducteur interne (32) opposée à l'électrode de couplage.

14. Agencement de circuit selon la revendication 12 ou 13, **caractérisé en outre en ce que** le circuit de surveillance de ligne de connexion (38) est connecté à un potentiel de terre (50) via une connexion de terre (49) et est pour cela configuré pour détecter une déviation de potentiel sur la connexion de terre (49).
